# EUROPEAN PATENT APPLICATION

(11) **EP 4 642 183 A1**
(43) Date of publication of application: **29.10.2025**
(21) Application number: 24219234.2
(22) Date of filing: 11.12.2024
(51) Int. Cl.: H10B 12/00

(54) **SEMICONDUCTOR DEVICE**

(30) Priority: 25.04.2024 KR 20240055337
(71) Applicant: Samsung Electronics Co., Ltd., Suwon-si, Gyeonggi-do 16677 (KR)
(72) Inventor: BAE, Sunghoon, 16677 Suwon-si (KR); KO, Seung-Bo, 16677 Suwon-si (KR)
(74) Representative: Marks & Clerk LLP

(57) **Abstract**

A semiconductor device may include a substrate including a cell region and a peripheral region; an active pattern on the cell region of the substrate; a gate structure on the active pattern and extending in a first direction; a bit line structure electrically connected to the active pattern and extending in a second direction crossing the first direction; a node contact electrically connected to the active pattern; a landing pad electrically connected to the node contact; a conductive structure on the peripheral region; a division structure enclosing the landing pad, the division structure including a first division pattern on the bit line structure and a second division pattern between the landing pad and the conductive structure; and an insulating structure on the second division pattern.

## Description

### BACKGROUND

The present disclosure relates to a semiconductor device, and in particular, to a semiconductor device including an insulating structure.

Due to their small-sized, multifunctional, and/or low-cost characteristics, semiconductor devices may be important elements in the electronics industry. Semiconductor devices may be classified as a semiconductor memory device for storing data, a semiconductor logic device for processing data, and a hybrid semiconductor device including both of memory and logic elements.

With the recent trend of high speed and low power consumption of electronic devices, semiconductor devices in the electronic devices may be required to have high operating speeds and/or low operating voltages, and it may be necessary to increase an integration density of the semiconductor device. However, as the integration density of the semiconductor device increases, the semiconductor device may suffer from deteriorated electrical characteristics and low production yield. Accordingly, many studies are being conducted to improve the electrical characteristics and production yield of the semiconductor device.

### SUMMARY

An embodiment of inventive concepts provides a semiconductor device with improved electrical characteristics.

According to an embodiment of inventive concepts, a semiconductor device may include a substrate including a cell region and a peripheral region; an active pattern on the cell region of the substrate; a gate structure on the active pattern and extending in a first direction; a bit line structure electrically connected to the active pattern and extending in a second direction, the second direction crossing the first direction; a node contact electrically connected to the active pattern; a landing pad electrically connected to the node contact; a conductive structure on the peripheral region; a division structure enclosing the landing pad, the division structure including a first division pattern on the bit line structure and a second division pattern between the landing pad and the conductive structure; and an insulating structure on the second division pattern. A first side surface of the insulating structure may be in contact with the conductive structure. A second side surface of the insulating structure may be opposite the first side surface of the insulating structure. A bottom surface of the insulating structure may connect the first side surface of the insulating structure to the second side surface of the insulating structure. A level of the bottom surface of the insulating structure may be lower than a level of a top surface of the landing pad and higher than a level of a lowest portion of the second division pattern.

According to an embodiment of inventive concepts, a semiconductor device may include a substrate including a cell region and a peripheral region; an active pattern on the cell region of the substrate; a gate structure on the active pattern and extending in a first direction; a bit line structure electrically connected to the active pattern and extending in a second direction, the second direction crossing the first direction; a node contact electrically connected to the active pattern; a landing pad electrically connected to the node contact; a conductive structure on the peripheral region; a division structure enclosing the landing pad, the division structure including a first division pattern on the bit line structure and a second division pattern between the landing pad and the conductive structure; and an insulating structure on the second division pattern. The insulating structure may be between the landing pad and the conductive structure, and a side surface of the conductive structure may be in contact with the second division pattern and the insulating structure.

According to an embodiment of inventive concepts, a semiconductor device may include a substrate including a cell region and a peripheral region; an active pattern on the cell region of the substrate; a gate structure on the active pattern and extending in a first direction; a bit line structure electrically connected to the active pattern and extending in a second direction, the second direction crossing the first direction; a node contact electrically connected to the active pattern; a landing pad electrically connected to the node contact; a dummy line structure on the cell region and the peripheral region; a peripheral gate structure on the peripheral region; a conductive structure connected to the peripheral gate structure; a division structure enclosing the landing pad, the division structure including a first division pattern on the bit line structure and a second division pattern between the landing pad and the conductive structure; an insulating structure on the second division pattern; and an upper insulating layer covering the division structure, the insulating structure, and the conductive structure. The second division pattern and the insulating structure may be between the landing pad and the conductive structure. A bottom surface of the insulating structure may be in contact with the second division pattern, and a top surface of the insulating structure may be in contact with the upper insulating layer.

At least some of the above and other features of the disclosure are set out in the claims.

### BRIEF DESCRIPTION OF THE DRAWINGS

FIG. 1A is a plan view illustrating a semiconductor device according to an embodiment of inventive concepts.
FIG. 1B is an enlarged plan view illustrating a portion 'E1' of FIG. 1A.
FIG. 1C is a sectional view taken along line A-A' of FIG. 1B.
FIG. 1D is a sectional view taken along line B-B' of FIG. 1B.
FIG. 1E is an enlarged sectional view illustrating a portion 'E2' of FIG. 1C.
FIGS. 2A, 2B, 3A, 3B, 4A, 4B, 5A, 5B, 6A, and 6B are plan views and sectional views illustrating operations of a method of fabricating a semiconductor device, according to an embodiment of inventive concepts.
FIG. 7 is an enlarged view illustrating a semiconductor device according to an embodiment of inventive concepts.
FIG. 8 is an enlarged view illustrating a semiconductor device according to an embodiment of inventive concepts.
FIG. 9 is a sectional view illustrating a semiconductor device according to an embodiment of inventive concepts.

### DETAILED DESCRIPTION

Example embodiments of inventive concepts will now be described more fully with reference to the accompanying drawings, in which some example embodiments are shown.

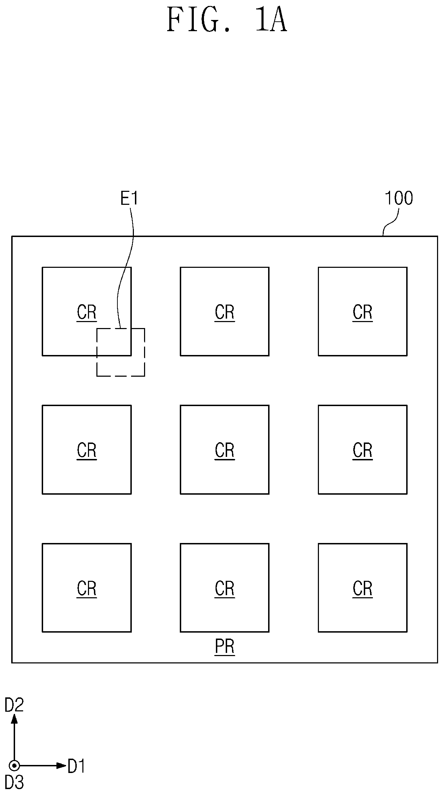

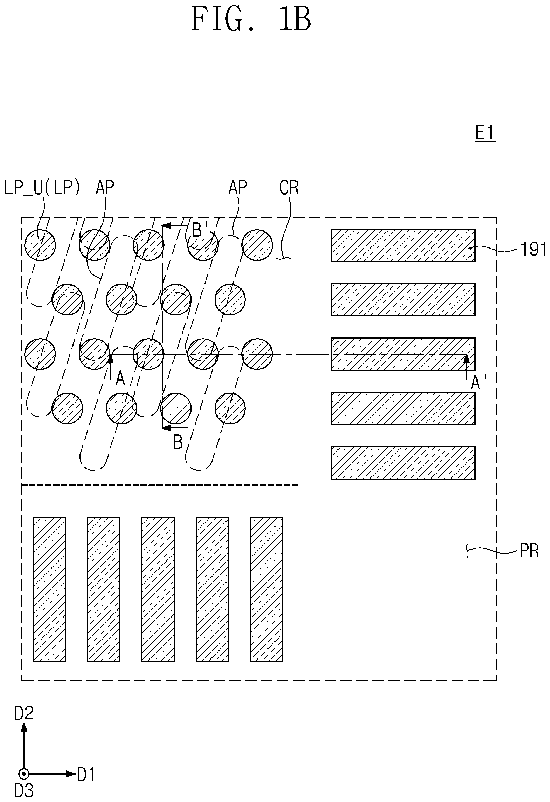

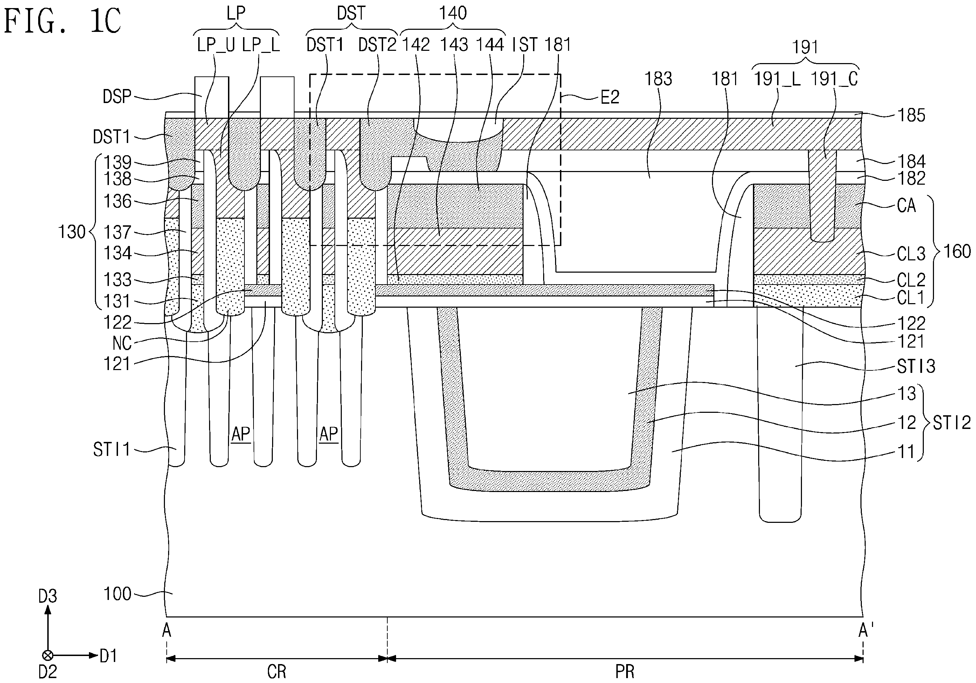

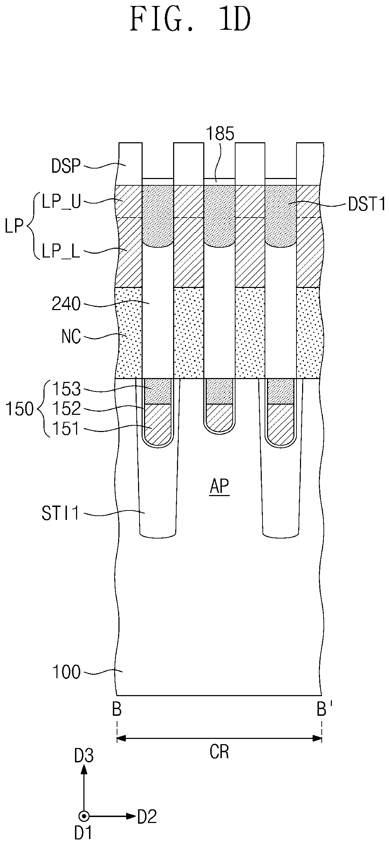

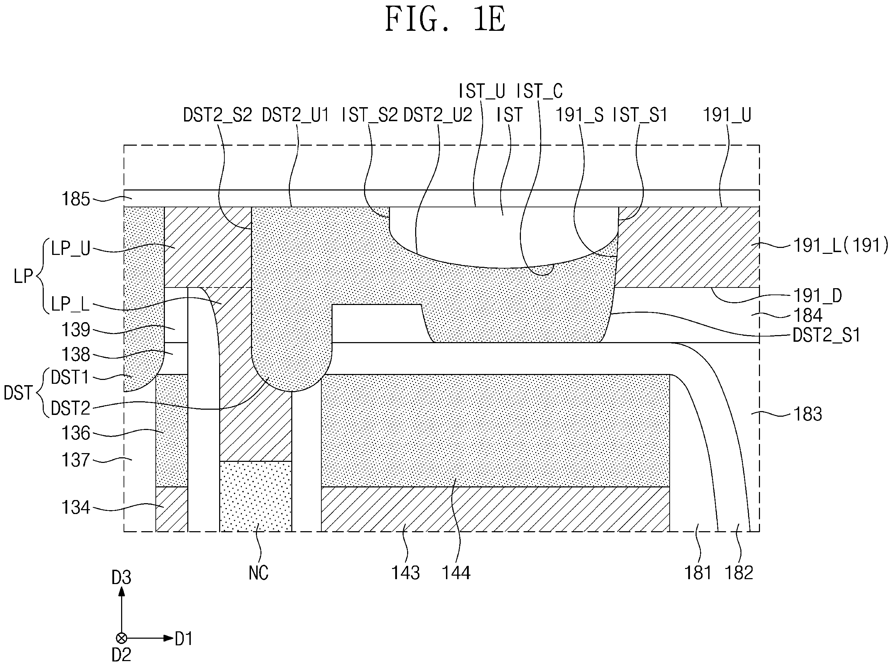

FIG. 1A is a plan view illustrating a semiconductor device according to an embodiment of inventive concepts. FIG. 1B is an enlarged plan view illustrating a portion `E1' of FIG. 1A. FIG. 1C is a sectional view taken along line A-A' of FIG. 1B. FIG. 1D is a sectional view taken along line B-B' of FIG. 1B. FIG. 1E is an enlarged sectional view illustrating a portion 'E2' of FIG. 1C.

Referring to FIGS. 1A to 1E, the semiconductor device may include a substrate 100. In an embodiment, the substrate 100 may be a semiconductor substrate. As an example, the substrate 100 may be formed of or include silicon, germanium, silicon-germanium, GaP, or GaAs. In an embodiment, the substrate 100 may be a semiconductor on insulator substrate, such as a silicon-on-insulator (SOI) substrate or a germanium-on-insulator (GOI) substrate. The substrate 100 may have a shape of a plate, which is extended in a first direction D1 and a second direction D2. The first and second directions D1 and D2 may not be parallel to each other. As an example, the first and second directions D1 and D2 may be horizontal directions that are orthogonal to each other. The first direction D1 may be the X-axis. The second direction D2 may be the Z-axis.

The substrate 100 may include cell regions CR and a peripheral region PR. The peripheral region PR may enclose the cell regions CR. The peripheral region PR may surround the cell regions CR in the first and second direction D1, D2.

The cell region CR of the substrate 100 may include active patterns AP. Upper portions of the cell region CR of the substrate 100, which are extended in a third direction D3, may be defined as the active patterns AP. The third direction D3 may not be parallel to the first and second directions D1 and D2. As an example, the third direction D3 may be a vertical direction that is orthogonal to the first and second directions D1 and D2. The third direction D3 may be Z-axis. The active patterns AP may be spaced apart from each other. The active patterns AP may be spaced apart from each other in the first and/or second directions D1, D2.

A first device isolation layer STI1 may be provided to define the active patterns AP. The first device isolation layer STI1 may be provided in the cell region CR of the substrate 100. Each of the active patterns AP may be enclosed by the first device isolation layer STI1. The first device isolation layer STI1 may at least partially surround each of the active pattern AP in the first and/or second direction D1, D2.

A second device isolation layer STI2 and a third device isolation layer STI3 may be provided in the substrate 100. The second device isolation layer STI2 and the third device isolation layer STI3 may be provided on the peripheral region PR. The second device isolation layer STI2 may be disposed between the first device isolation layer STI1 and the third device isolation layer STI3 in, for example, the first direction D1. In an embodiment, the first and second device isolation layers STI1 and STI2 may be connected to each other without any interface therebetween to form a single object.

The first and third device isolation layers STI1 and STI3 may include an insulating material. In an embodiment, the first and third device isolation layers STI1 and STI3 may be formed of or include at least one of oxide or nitride materials. The second device isolation layer STI2 may include a first insulating layer 11, a second insulating layer 12 on the first insulating layer 11, and a third insulating layer 13 on the second insulating layer 12. In an embodiment, the first insulating layer 11 may include an oxide material, the second insulating layer 12 may include a nitride material, and the third insulating layer 13 may include an oxide material.

Cell gate structures 150 may be provided to extend in the first direction D1. The cell gate structures 150 may be arranged in the second direction D2. The cell gate structure 150 may be provided on the cell region CR of the substrate 100. The cell gate structure 150 may be provided on the first device isolation layer STI1 and the active patterns AP. The cell gate structure 150 may be a buried gate structure, which is buried in the active patterns AP and the first device isolation layer STI1. The active patterns AP may include impurity regions. A cell transistor may be defined by the cell gate structure 150 and the active pattern AP.

The cell gate structure 150 may include a gate insulating layer 152 on the active pattern AP, a gate electrode 151 on the gate insulating layer 152, and a gate capping layer 153 on the gate electrode 151. The gate insulating layer 152 and the gate capping layer 153 may include an insulating material. As an example, the gate insulating layer 152 may include an oxide material, and the gate capping layer 153 may include a nitride material. The gate electrode 151 may include a conductive material.

The active pattern AP may include one first portion and two second portions. The first portion of the active pattern AP may be disposed between the two second portions of the active pattern AP. The cell gate structure 150 may be provided between the first and second portions of the active pattern AP. The first and second portions of the active pattern AP may be spaced apart from each other by the cell gate structure 150.

First insulating patterns 121 may be provided on the cell gate structure 150, the first device isolation layer STI1, the second device isolation layer STI2, and the third device isolation layer STI3. Second insulating patterns 122 may be provided on, for example in the third direction D3, the first insulating patterns 121, respectively. The first insulating pattern 121 and the second insulating pattern 122 may include an insulating material. In an embodiment, the first insulating pattern 121 may include an oxide material, and the second insulating pattern 122 may include a nitride material. In an embodiment, the first insulating pattern 121 and the second insulating pattern 122 may include a plurality of insulating layers.

Bit line structures 130 may be provided to extend in the second direction D2. The bit line structures 130 may be arranged in the first direction D1. The bit line structure 130 may be provided on the cell region CR of the substrate 100. The bit line structure 130 may be provided on the second insulating pattern 122 and the active pattern AP. The bit line structure 130 may be electrically connected to the active pattern AP.

Each of the bit line structures 130 may include a bit line contact 131, a first conductive layer 133, a second conductive layer 134, a bit line capping layer 136, a bit line spacer 137, a first bit line insulating layer 138, and a second bit line insulating layer 139.

The bit line contacts 131 of the bit line structure 130 may be arranged in the first direction D1 or the second direction D2. The bit line contact 131 may be disposed on the first portion of the active pattern AP. The bit line contact 131 may be provided to penetrate the first insulating pattern 121 and the second insulating pattern 122. The first conductive layer 133 may be provided on the first insulating pattern 121 and the second insulating pattern 122. The bit line contact 131 may include a conductive material. In an embodiment, the bit line contact 131 may be formed of or include poly silicon.

The first conductive layer 133 may be provided on the bit line contacts 131 and the second insulating patterns 122. The second conductive layer 134 may be provided on the first conductive layer 133. The bit line capping layer 136 may be provided on the second conductive layer 134. The first bit line insulating layer 138 may be provided on the bit line capping layer 136. The second bit line insulating layer 139 may be provided on the first bit line insulating layer 138.

The first conductive layer 133 and the second conductive layer 134 may include a conductive material. In an embodiment, the first conductive layer 133 may be formed of or include poly silicon, and the second conductive layer 134 may be formed of or include a metallic material. The bit line capping layer 136, the first bit line insulating layer 138, and the second bit line insulating layer 139 may include an insulating material. In an embodiment, the number of the conductive layers, which are included in one bit line structure 130, may be greater or less than that in the illustrated example.

The bit line spacer 137 may cover a side surface of the bit line contact 131, a side surface of the first conductive layer 133, a side surface of the second conductive layer 134, a side surface of the bit line capping layer 136, a side surface of the first insulating pattern 121, and side and top surfaces of the second insulating pattern 122. The bit line spacer 137 may include an insulating material. In an embodiment, the bit line spacer 137 may include a plurality of insulating layers.

Node contacts NC may be provided. The node contact NC may be provided on the cell region CR of the substrate 100. The node contacts NC may be provided in the cell region CR of the substrate 100. The node contact NC may be provided on the second portion of the active pattern AP. The node contact NC may be electrically connected to the active pattern AP. The or each node contact NC may be provided between the bit line structures 130, e.g., in the first direction D1, which are adjacent to each other. The node contact NC may be provided on a side surface of the bit line structure 130. The node contact NC may include a conductive material. As an example, the node contact NC may be formed of or include poly silicon.

Landing pads LP may be provided. The landing pad LP may be provided on the node contact NC, e.g., in the third direction D3. The landing pad LP may be electrically connected to the node contact NC. The landing pad LP may include a conductive material. In an embodiment, the landing pad LP may be formed of or include a metallic material. In an embodiment, a metal silicide layer may be provided between the node contact NC and the landing pad LP. In an embodiment, a barrier layer may be provided between the node contact NC and the landing pad LP.

The landing pad LP may include an upper portion LP_U and a lower portion LP_L. The upper portion LP_U may be a portion of the landing pad LP located at a level higher than the bit line structure 130. The lower portion LP_L may be a portion of the landing pad LP connected to the node contact NC. The upper portion LP_U of the landing pad LP may be provided on, e.g., in the third direction D3, the lower portion LP_L of the landing pad LP. A portion of the upper portion LP_U of the landing pad LP may be overlapped with a portion of the node contact NC in the third direction D3. In an embodiment, the entirety of the landing pad LP may be placed at a level that is higher than the bit line structure 130.

Insulating fences 240 may be provided. The insulating fence 240 may be provided on, e.g., in the third direction D3, the gate capping layer 153 of the cell gate structure 150. The insulating fence 240 may be provided between the node contacts NC, which are adjacent to each other in the second direction D2. The insulating fence 240 may be provided between the bit line structures 130, which are adjacent to each other in the first direction D1. The insulating fence 240 may include an insulating material.

Data storage patterns DSP may be provided. The data storage pattern DSP may be electrically connected to the active pattern AP through the landing pad LP and the node contact NC. In an embodiment, each of the data storage patterns DSP may be a capacitor including a bottom electrode, a dielectric layer, and a top electrode. In this case, the semiconductor device including the data storage patterns DSP may be a dynamic random access memory (DRAM) device. In an embodiment, each of the data storage patterns DSP may include a magnetic tunnel junction pattern. In this case, the semiconductor device including the data storage patterns DSP may be a magnetic random access memory (MRAM) device. In an embodiment, the data storage patterns DSP may include a phase-change material or a variable resistance material. In this case, the semiconductor device including the data storage patterns DSP may be a phase-change random access memory (PRAM) device or a resistive random access memory (ReRAM) device. In an embodiment, each of the data storage patterns DSP may include various structures and/or materials which can be used to store data.

A dummy line structure 140 may be provided. The dummy line structure 140 may be provided on the peripheral region PR of the substrate 100. The dummy line structure 140 may be provided in the peripheral region PR of the substrate 100. The dummy line structure 140 may be extended in the second direction D2. The dummy line structure 140 may be disposed between a peripheral gate structure 160, which will be described below, and the bit line structure 130.

The dummy line structure 140 may include a first dummy conductive layer 142 on the second insulating pattern 122, a second dummy conductive layer 143 on the first dummy conductive layer 142, and a dummy capping layer 144 on the second dummy conductive layer 143, e.g., in the third direction D3. The first and second dummy conductive layers 142 and 143 may include a conductive material. In an embodiment, the first dummy conductive layers 142 may be formed of or include poly silicon, and the second dummy conductive layer 143 may be formed of or include at least one of metallic materials. The dummy capping layer 144 may include an insulating material.

Peripheral gate structures 160 may be provided. The peripheral gate structure 160 may be provided on the peripheral region PR of the substrate 100. The peripheral gate structure 160 may be provided in the peripheral region PR of the substrate 100. In an embodiment, the peripheral gate structure 160 may be a gate of a transistor constituting a subword line driver or a sense-amplifier.

The peripheral gate structure 160 may include a first peripheral conductive layer CL1, a second peripheral conductive layer CL2 on the first peripheral conductive layer CL1 (e.g., in the third direction D3), a third peripheral conductive layer CL3 on the second peripheral conductive layer CL2 (e.g., in the third direction D3), and a peripheral capping layer CA on the third peripheral conductive layer CL3 (e.g., in the third direction D3). The first to third peripheral conductive layers CL1, CL2, and CL3 may include a conductive material. In an embodiment, the first and second peripheral conductive layers CL1 and CL2 may be formed of or include poly silicon, and the third peripheral conductive layer CL3 may be formed of or include a metallic material. The peripheral capping layer CA may include an insulating material.

First peripheral spacers 181 may be provided on the peripheral region PR of the substrate 100. First peripheral spacers 181 may be provided in the peripheral region PR of the substrate 100. The first peripheral spacers 181 may be provided on a side surface of the dummy line structure 140 and a side surface of the peripheral gate structure 160, e.g., in the first direction D1. The first peripheral spacer 181 may cover a side surface of the first dummy conductive layer 142, a side surface of the second dummy conductive layer 143, and a side surface of the dummy capping layer 144. The first peripheral spacer 181 may cover a side surface of the first peripheral conductive layer CL1, a side surface of the second peripheral conductive layer CL2, a side surface of the third peripheral conductive layer CL3, and a side surface of the peripheral capping layer CA. The first peripheral spacer 181 may include an insulating material.

A second peripheral spacer 182 may be provided on the peripheral region PR of the substrate 100. A second peripheral spacer 182 may be provided in the peripheral region PR of the substrate 100. The second peripheral spacer 182 may be provided on the dummy line structure 140, the peripheral gate structure 160, and the first peripheral spacers 181, e.g., in the third direction D3. The second peripheral spacer 182 may cover a top surface of the dummy capping layer 144, a top surface of the peripheral capping layer CA, and a side surface of the first peripheral spacers 181. The second peripheral spacer 182 may include an insulating material.

A first filling insulating layer 183 may be provided on the second peripheral spacer 182, e.g., in the first and/or third directions D1, D3. The first filling insulating layer 183 may include a portion provided between the dummy line structure 140 and the peripheral gate structure 160. The first filling insulating layer 183 may include an insulating material.

A second filling insulating layer 184 may be provided on the first filling insulating layer 183 and the second peripheral spacer 182, e.g., in the third direction D3. The second filling insulating layer 184 may include an insulating material.

Conductive structures 191 may be provided on the second filling insulating layer 184, e.g., in the third direction D3. The conductive structures 191 may be provided on the peripheral region PR of the substrate 100. The conductive structures 191 may be provided in the peripheral region PR of the substrate 100. The conductive structure 191 may include a conductive material. In an embodiment, the conductive structure 191 may be formed of or include at least one of metallic materials.

Each of the conductive structures 191 may include a contact portion 191_C and a line portion 191_L on the contact portion 191_C. The contact portion 191_C of the conductive structure 191 may be provided to penetrate the second filling insulating layer 184, the second peripheral spacer 182, and the peripheral capping layer CA. The contact portion 191_C of the conductive structure 191 may be in contact with the third peripheral conductive layer CL3 of the peripheral gate structure 160. The line portion 191_L may be electrically connected to the peripheral gate structure 160 through the contact portion 191_C. The line portion 191_L of the conductive structure 191 may be extended in the first direction D1 or the second direction D2. The line portion 191_L of the conductive structure 191 may be a bar-shaped pattern that is extended in a horizontal direction.

A division structure DST may be provided to enclose the landing pads LP and the conductive structure 191. The division structure DST may surround the landing pads and/or conductive structure 191 in the first and/or second direction D1, D2. The division structure DST may include an insulating material. In an embodiment, the division structure DST may be formed of or include at least one of SiN, SiOCN, SiOC, SiCN, or SiBN.

The division structure DST may include a first division pattern DST1 and a second division pattern DST2. The first and second division patterns DST1 and DST2 may be connected to each other without any interface therebetween to form a single object. In an embodiment, the first and second division patterns DST1 and DST2 may be distinguishable or separated from each other by a boundary therebetween.

The first division pattern DST1 may be provided on the cell region CR. The first division pattern DST1 may be provided in the cell region CR. The first division pattern DST1 may be disposed on the bit line structure 130, e.g., in the third direction D3. The first division pattern DST1 may enclose the landing pads LP. The first division pattern DST1 may separate the landing pads LP from each other.

The second division pattern DST2 may be provided on the peripheral region PR. The second division pattern DST2 may be provided between the landing pad LP and the conductive structure 191, e.g., in the first direction. The second division pattern DST2 may separate the landing pad LP from the conductive structure 191. The second division pattern DST2 may be overlapped with the dummy line structure 140. At least a portion of the second division pattern DST2 may overlay at least a portion of the dummy line structure 140. The first and second filling insulating layers 183 and 184 may be interposed between the second division pattern DST2 and the dummy line structure 140. In an embodiment, the first and second filling insulating layers 183 and 184 may not be interposed between the second division pattern DST2 and the dummy line structure 140. The second division pattern DST2 may be provided to penetrate the second filling insulating layer 184. In an embodiment, the second division pattern DST2 may be provided to penetrate the first and second filling insulating layers 183 and 184.

An insulating structure IST may be provided on the peripheral region PR. An insulating structure IST may be provided in the peripheral region PR. The insulating structure IST may be provided on the second division pattern DST2, e.g., in the first and/or third directions D1, D3. The insulating structure IST may be in contact with the second division pattern DST2, the conductive structure 191, and an upper insulating layer 185. The insulating structure IST may be spaced apart from the landing pad LP. The insulating structure IST may include an insulating material. As an example, the insulating structure IST may be formed of or include at least one of SiN, SiOCN, SiOC, SiCN, or SiBN. The insulating structure IST may consist of an insulating material.

The upper insulating layer 185 may be provided on the division structure DST, the landing pads LP, the insulating structure IST, and the conductive structures 191. The upper insulating layer 185 may enclose side surfaces of the data storage patterns DSP. The upper insulating layer 185 may include an insulating material. In an embodiment, the upper insulating layer 185 may include SiBN.

The division structure DST and the insulating structure IST may be formed of or include insulating materials that are different from each other. In an embodiment, the division structure DST may include a nitride material, and the insulating structure IST may include an oxide material. Alternatively, in an embodiment, the division structure DST and the insulating structure IST may be formed of or include the same insulating material.

Referring to FIG. 1E, the insulating structure IST may include a first side surface IST_S1, a second side surface IST_S2, a top surface IST_U, and a bottom surface IST_C. The first side surface IST_S1 of the insulating structure IST may connect the top surface IST_U and the bottom surface IST_C of the insulating structure IST to each other. The second side surface IST_S2 of the insulating structure IST may connect the top surface IST_U and the bottom surface IST_C of the insulating structure IST to each other. The second side surface IST_S2 of the insulating structure IST may be opposite to the first side surface IST_S1 of the insulating structure IST.

The first side surface IST_S1 of the insulating structure IST may be in contact with a side surface of the line portion 191_L of the conductive structure 191. The second side surface IST_S2 and the bottom surface IST_C of the insulating structure IST may be in contact with the second division pattern DST2. The second side surface IST_S2 of the insulating structure IST may be spaced apart from the landing pad LP. The top surface IST_U of the insulating structure IST may be in contact with the upper insulating layer 185.

The second division pattern DST2 may include a first side surface DST2_S1, a second side surface DST2_S2, a first top surface DST2_U1, and a second top surface DST2_U2. The first side surface DST2_S1 of the second division pattern DST2 may be in contact with the landing pad LP. The second side surface DST2_S2 of the second division pattern DST2 may be in contact with the second filling insulating layer 184 and the line portion 191_L of the conductive structure 191. The first top surface DST2_U1 of the second division pattern DST2 may be in contact with the upper insulating layer 185. The second top surface DST2_U2 of the second division pattern DST2 may be in contact with the bottom surface IST_C of the insulating structure IST.

The conductive structure 191 may include a bottom surface 191_D, a top surface 191_U, and a side surface 191_S. The bottom, top, and side surfaces 191_D, 191_U, and 191_S of the conductive structure 191 may be bottom, top, and side surfaces of the line portion 191 _L of the conductive structure 191. The bottom surface 191 _D of the conductive structure 191 may be in contact with the second filling insulating layer 184. The top surface 191_U of the conductive structure 191 may be in contact with the upper insulating layer 185. The side surface 191_S of the conductive structure 191 may connect the bottom surface 191_D and the top surface 191_U of the conductive structure 191 to each other. The side surface 191_S of the conductive structure 191 may be in contact with the first side surface DST2_S1 of the second division pattern DST2 and the first side surface IST_S1 of the insulating structure IST.

A level of the bottom surface IST_C of the insulating structure IST may be higher than a level of the lowest portion of the second division pattern DST2. The level of the bottom surface IST_C of the insulating structure IST may be lower than a level of the top surface 191_U of the conductive structure 191. The level of the bottom surface IST_C of the insulating structure IST may be higher than a level of the bottom surface of the line portion 191_L of the conductive structure 191. The level of the bottom surface IST_C of the insulating structure IST may be lower than a level of a top surface of the landing pad LP. The level of the bottom surface IST_C of the insulating structure IST may be higher than a level of the lower portion LP_L of the landing pad LP. In an embodiment, the level of the bottom surface IST_C of the insulating structure IST may be lower than a level of the upper portion LP_U of the landing pad LP. The levels may be in the third direction D3. The levels may be relative to the substrate 100.

A level of the first top surface DST2_U1 of the second division pattern DST2 may be higher than a level of the second top surface DST2_U2 of the second division pattern DST2.

A thickness of the insulating structure IST may be smaller than a thickness of the line portion 191_L of the conductive structure 191. The thickness of the insulating structure IST may be smaller than the thickness of the upper portion LP_U of the landing pad LP. In an embodiment, the thickness of the insulating structure IST may be larger than the thickness of the line portion 191_L of the conductive structure 191. The thickness may be in third direction.

A width of the insulating structure IST in the first direction D1 may be smaller than the largest width of the second division pattern DST2 in the first direction D1. The width of the insulating structure IST in the first direction D1 may be smaller than the shortest distance between the landing pad LP and the conductive structure 191.

The top surface of the upper portion LP_U of the landing pad LP, the first top surface DST2_U1 of the second division pattern DST2, the top surface IST_U of the insulating structure IST, and the top surface 191_U of the conductive structure 191 may be coplanar with each other. The first side surface DST2_S1 of the second division pattern DST2 and the first side surface IST_S1 of the insulating structure IST may be coplanar with each other.

According to an embodiment of inventive concepts, the semiconductor device may include the insulating structure IST between the landing pad LP and the conductive structure 191. Since the insulating structure IST is included, the semiconductor device may not include a conductive material between the landing pad LP and the conductive structure 191. Thus, an electromagnetic interference issue may be reduced, and the electrical characteristics of the semiconductor device may be improved. In other words, the inclusion of an insulating structure IST between (e.g., in the first direction) the landing pad LP and the conductive structure 191 may reduce electromagnetic interference, and may improve electrical characteristics.

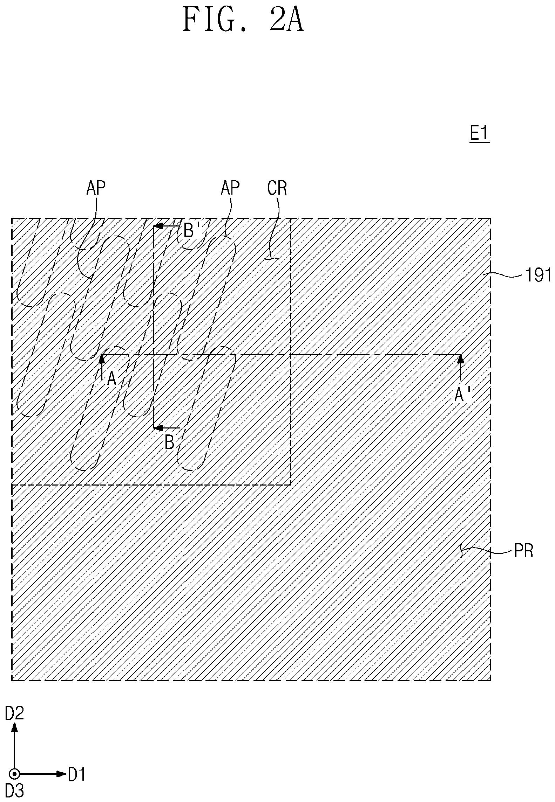

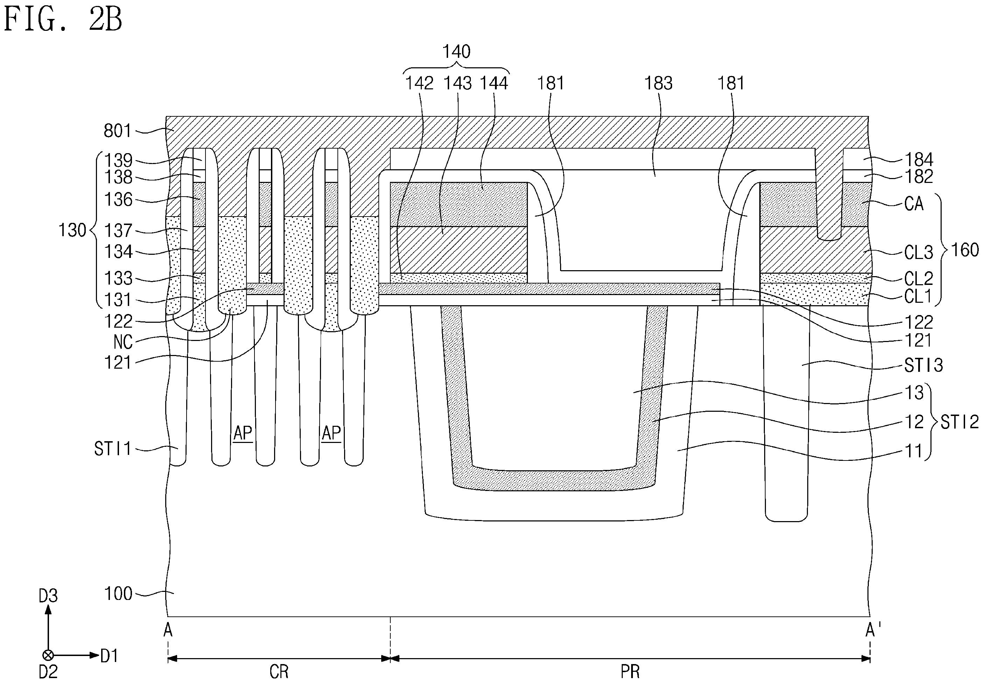

FIGS. 2A, 2B, 3A, 3B, 4A, 4B, 5A, 5B, 6A, and 6B are plan views and sectional views illustrating operations of a method of fabricating a semiconductor device, according to an embodiment of inventive concepts. FIGS. 2A, 3A, 4A, 5A, and 6A are plan views corresponding to FIG. 1B. FIGS. 2B, 3B, 4B, 5B, and 6B are sectional views corresponding to FIG. 1C.

Referring to FIGS. 2A and 2B, the substrate 100 including the cell region CR and the peripheral region PR may be provided. The first to third device isolation layers STI1, STI2, and STI3 may be formed on the substrate 100. The active patterns AP of the substrate 100 may be formed. The cell gate structures 150 (see FIG. 1D) may be formed on the cell region CR of the substrate 100. The first and second insulating patterns 121 and 122 may be formed on the substrate 100. The bit line structure 130, the dummy line structure 140, the peripheral gate structure 160, the first peripheral spacers 181, the second peripheral spacer 182, the first filling insulating layer 183, and the second filling insulating layer 184 may be formed. The bit line structure 130 may be formed on the cell region CR of the substrate 100. The dummy line structure 140 and the peripheral gate structure 160 may be formed on the peripheral region PR of the substrate 100.

The node contact NC and the insulating fence 240 may be formed (see FIG. 1D). A preliminary pad layer 801 may be formed on the node contact NC, the insulating fence 240, the bit line structure 130, and the second filling insulating layer 184. The preliminary pad layer 801 may be formed on the cell region CR and the peripheral region PR. The preliminary pad layer 801 may cover the bit line structure 130, the dummy line structure 140, and the peripheral gate structure 160. The preliminary pad layer 801 may include a conductive material.

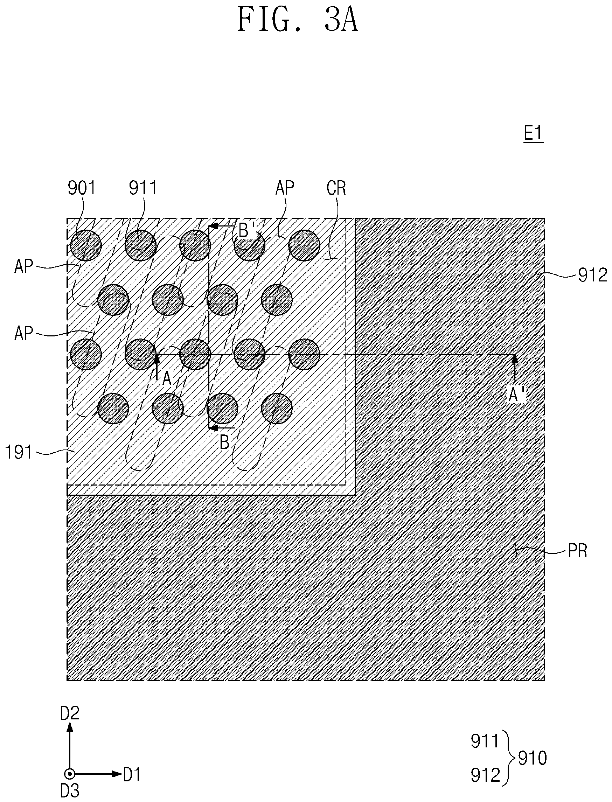

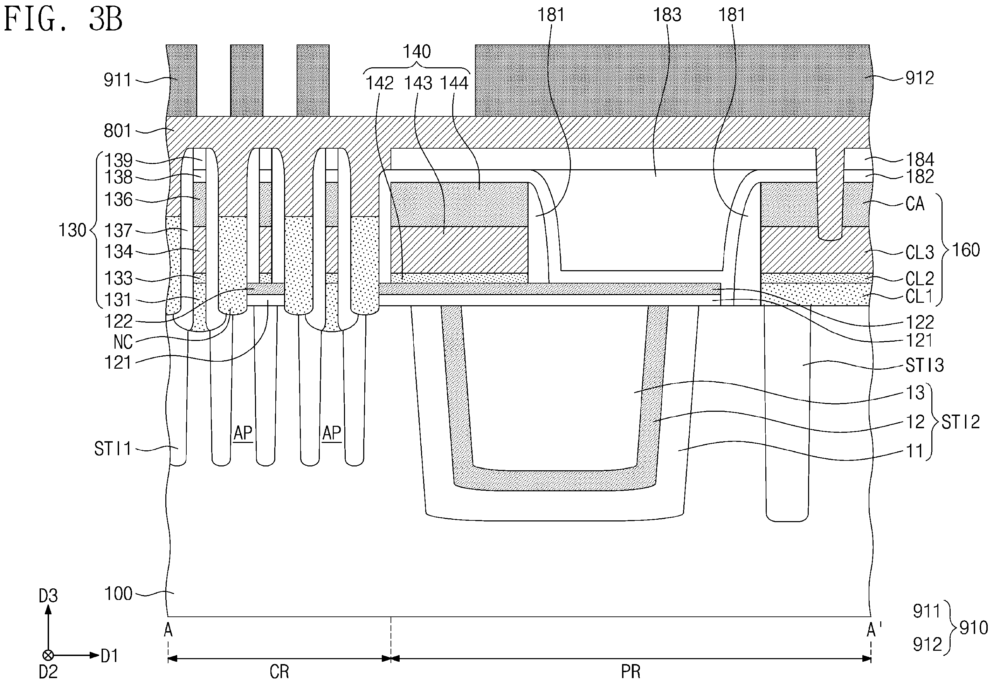

Referring to FIGS. 3A and 3B, a first photoresist layer 910 may be formed on the preliminary pad layer 801. The first photoresist layer 910 may include first cell mask patterns 911 and a first peripheral mask pattern 912. The formation of the first photoresist layer 910 may include forming a first preliminary photoresist layer and performing an exposure process and a developing process on the first preliminary photoresist layer to form the first cell mask patterns 911 and the first peripheral mask pattern 912.

The first cell mask patterns 911 may be formed on the cell region CR. Each of the first cell mask patterns 911 may be formed on a region where the landing pad LP will be formed. The first cell mask pattern 911 may have a circular shape, when viewed in a plan view. The first peripheral mask pattern 912 may be formed on the peripheral region PR. The first peripheral mask pattern 912 may be provided to enclose the cell region CR, when viewed in a plan view.

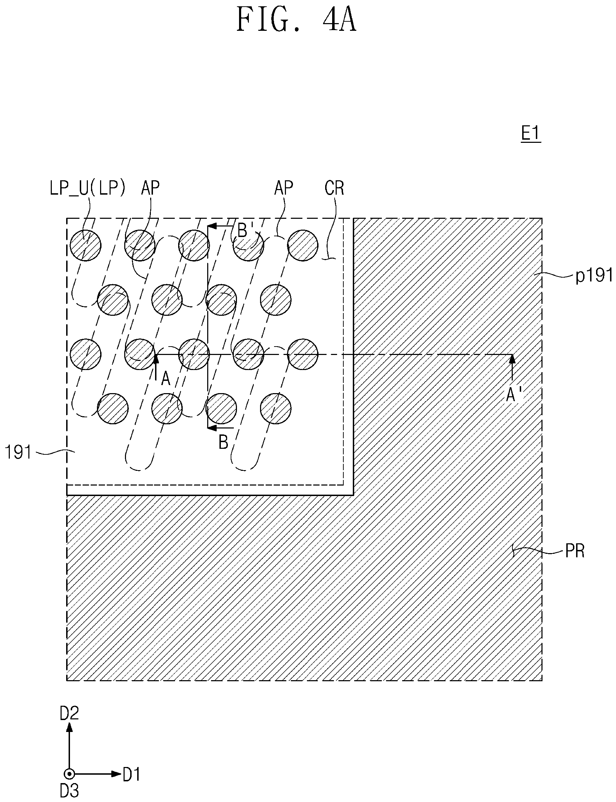

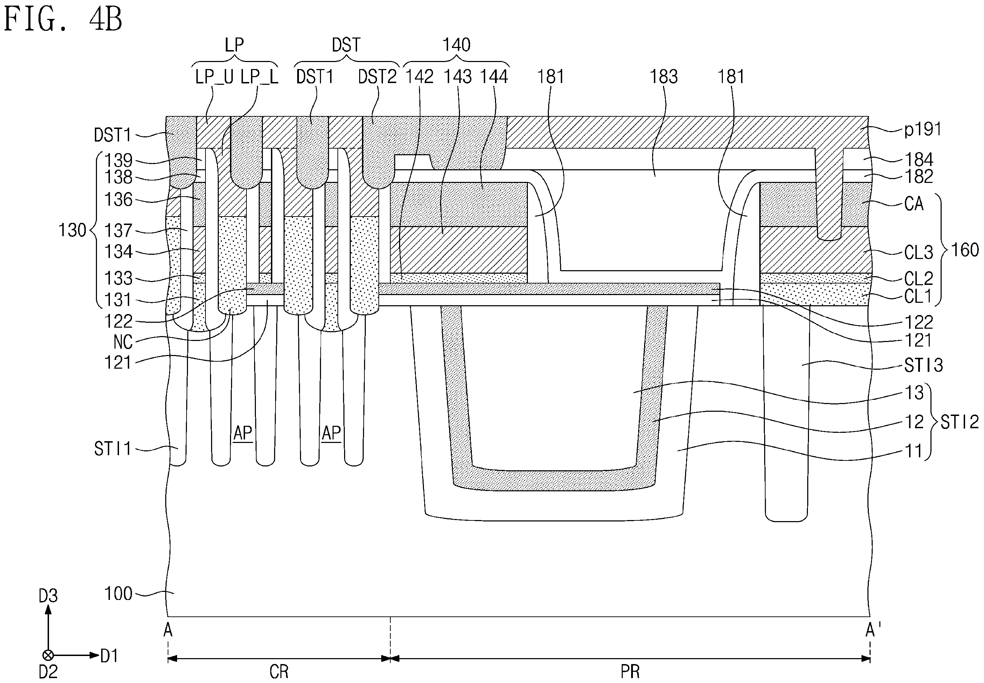

Referring to FIGS. 4A and 4B, the preliminary pad layer 801 may be etched using the first photoresist layer 910 as an etch mask. As a result of the etching of the preliminary pad layer 801, the preliminary pad layer 801 may be divided into the landing pads LP and a preliminary conductive structure p191. The division structure DST may be formed by filling an empty space, which is formed by etching the preliminary pad layer 801, with an insulating material. The division structure DST may include the first division pattern DST1 and the second division pattern DST2. After the formation of the division structure DST, the first photoresist layer 910 may be removed. In an embodiment, the preliminary pad layer 801 may be etched by a dry etching process.

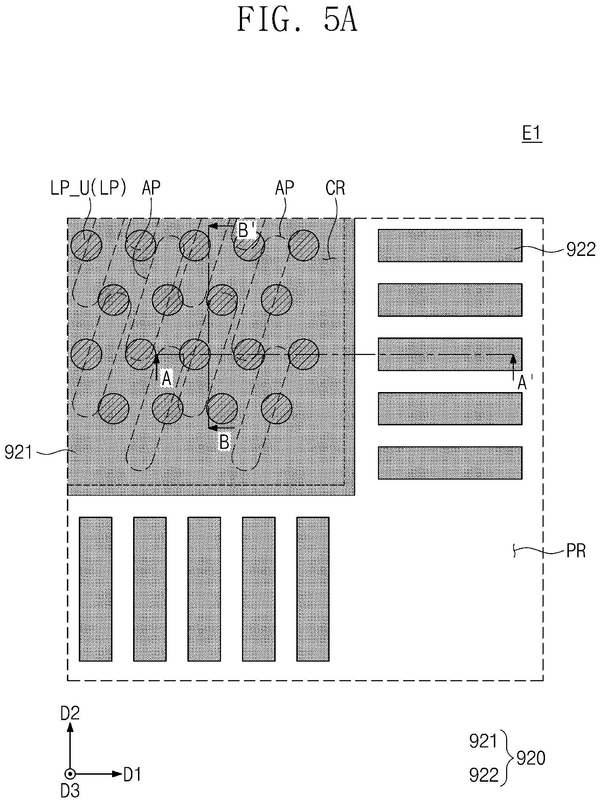

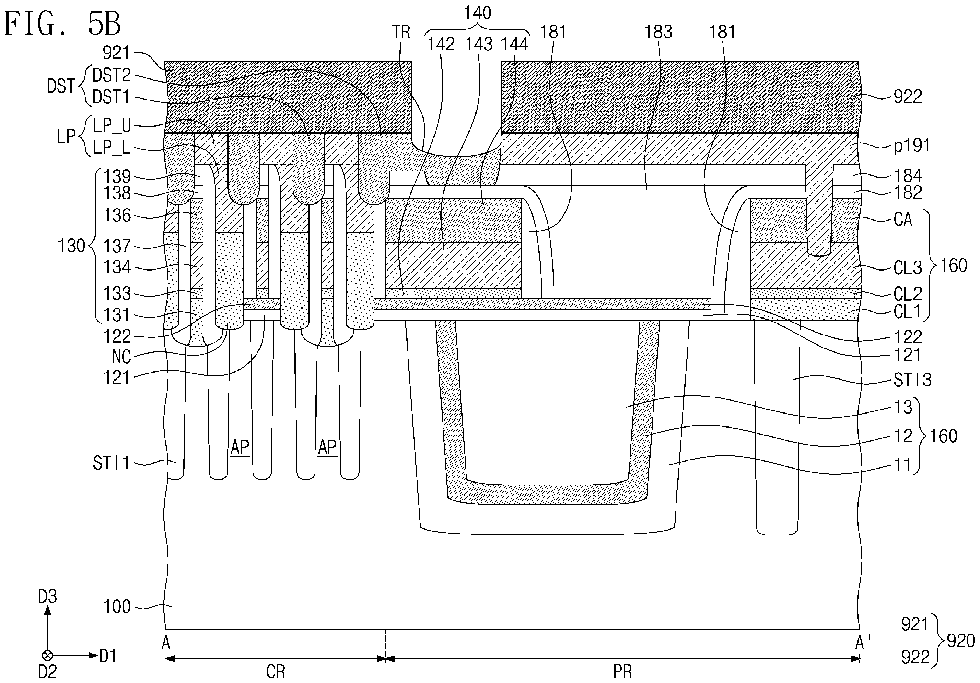

Referring to FIGS. 5A and 5B, a second photoresist layer 920 may be formed on the landing pads LP, the preliminary conductive structure p191, and the division structure DST. The second photoresist layer 920 may include a second cell mask pattern 921 and a second peripheral mask patterns 922. The formation of the second photoresist layer 920 may include forming a second preliminary photoresist layer and performing an exposure process and a developing process on the second preliminary photoresist layer to form the second cell mask pattern 921 and the second peripheral mask patterns 922.

The second cell mask pattern 921 may be formed on a portion of the peripheral region PR and the cell region CR. The second cell mask pattern 921 may cover the landing pads LP, the first division patterns DST1, and a portion of the second division pattern DST2. The second cell mask pattern 921 may have a tetragonal or rectangular shape, when viewed in a plan view. The second peripheral mask patterns 922 may be formed on the peripheral region PR. The second peripheral mask patterns 922 may be formed on the preliminary conductive structure p191. The second peripheral mask pattern 922 may have a rectangular shape, when viewed in a plan view.

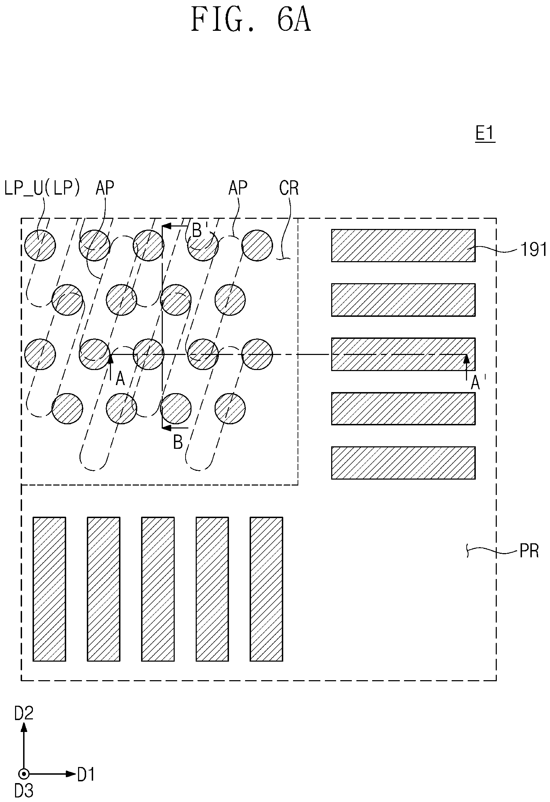

The second division pattern DST2 and the preliminary conductive structure p191 may be etched using the second photoresist layer 920 as an etch mask. A plurality of conductive structures 191 (see FIG. 6A) may be formed by etching the preliminary conductive structure p191. The trench TR may be formed by the etching of the second division pattern DST2 and the preliminary conductive structure p191. The second division pattern DST2 may be etched to expose a surface of the second division pattern DST2. The trench TR may be defined by the exposed surface of the second division pattern DST2. In an embodiment, the second division pattern DST2 and the preliminary conductive structure p191 may be etched by a dry etching process.

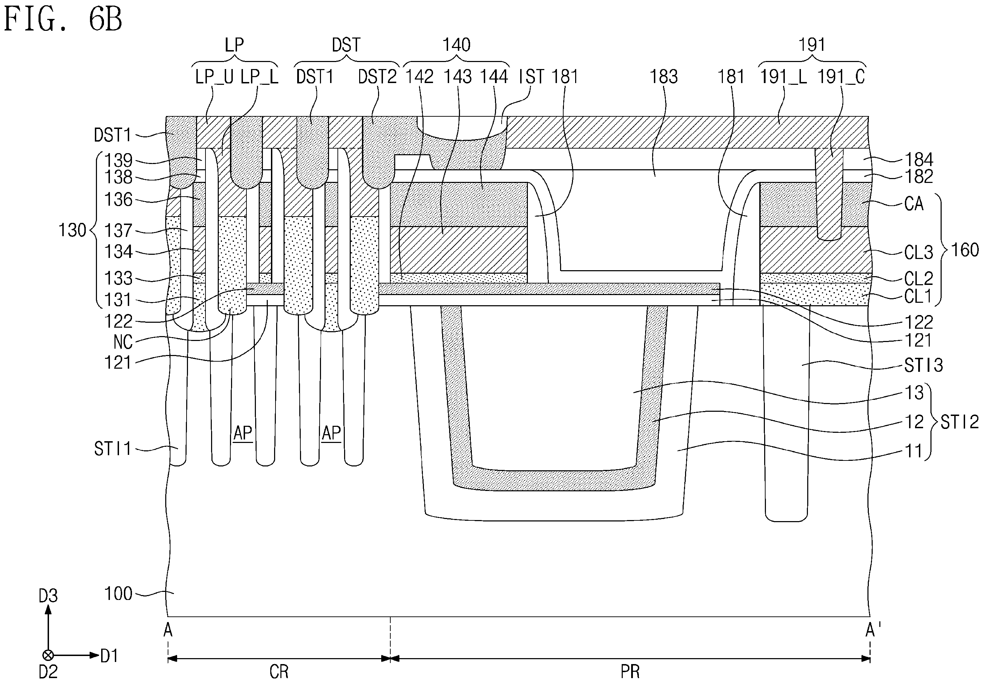

Referring to FIGS. 6A and 6B, the insulating structure IST may be formed. The insulating structure IST may be formed by filling the trench TR with an insulating material.

Referring back to FIGS. 1A to 1E, the upper insulating layer 185 may be formed on the division structure DST, the landing pads LP, and the conductive structures 191. The data storage patterns DSP may be formed to be connected to the landing pads LP, respectively.

According to the fabrication method, the landing pads LP and the conductive structures 191 may be formed to be spaced apart from each other. Thus, a distance between the landing pad LP and the conductive structure 191 may be reduced, and an integration density of the semiconductor device may be increased. The distance between the landing pad LP and the conductive structure 191 may be reduced compared to conventional semiconductor devices thereby increasing an integration density of the semiconductor device.

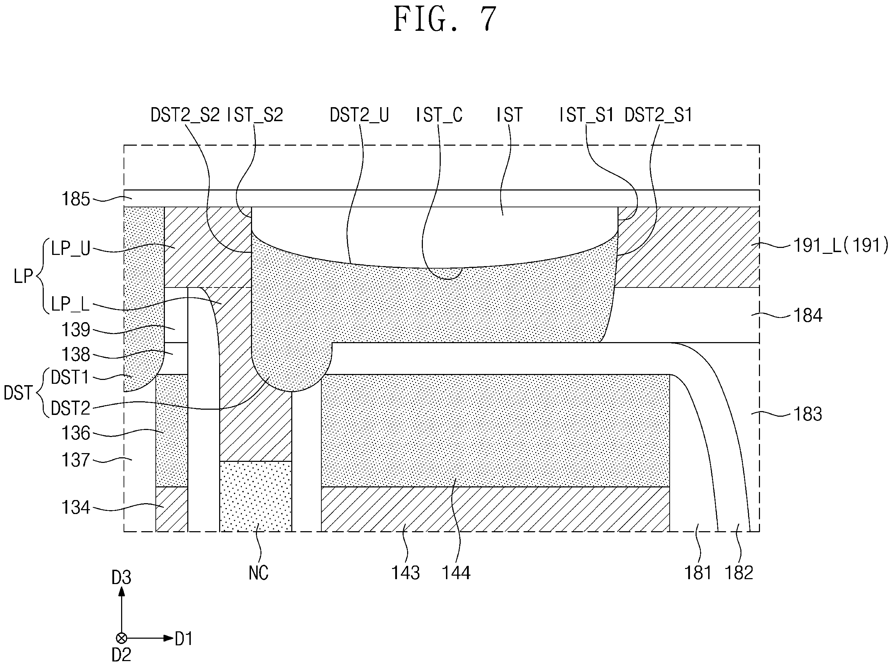

FIG. 7 is an enlarged view illustrating a semiconductor device according to an embodiment of inventive concepts. Except for the features to be described below, the semiconductor device of FIG. 7 may be the same as or similar to that of FIG. 1E.

Referring to FIG. 7, the second division pattern DST2 may be spaced apart from the upper insulating layer 185. A top surface DST2_U of the second division pattern DST2 may be fully covered with the bottom surface IST_C of the insulating structure IST. The bottom surface IST_C of the insulating structure IST may completely overlay a top surface DST2_U of the second division pattern DST2. The second peripheral spacer 182 may be interposed between the second division pattern DST2 and the dummy capping layer 144. In an embodiment, the second peripheral spacer 182 may not be interposed between the second division pattern DST2 and the dummy capping layer 144.

The insulating structure IST may be in contact with the upper portion LP_U of the landing pad LP. The insulating structure IST may be spaced apart from the lower portion LP_L of the landing pad LP. The second side surface IST_S2 of the insulating structure IST may be in contact with the upper portion LP_U of the landing pad LP.

A width of the insulating structure IST in the first direction D1 may be equal to the largest width of the second division pattern DST2 in the first direction D1.

The second side surface DST2_S2 of the second division pattern DST2 and the second side surface IST_S2 of the insulating structure IST may be coplanar with each other.

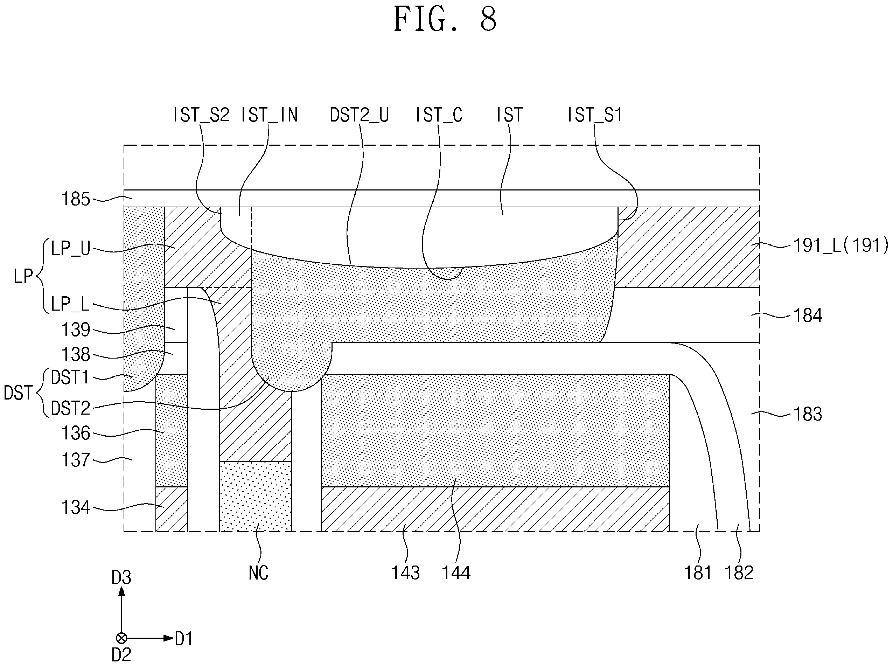

FIG. 8 is an enlarged view illustrating a semiconductor device according to an embodiment of inventive concepts. Except for the features to be described below, the semiconductor device of FIG. 8 may be the same as or similar to that of FIG. 1E.

Referring to FIG. 8, the second division pattern DST2 may be spaced apart from the upper insulating layer 185. The top surface DST2_U of the second division pattern DST2 may be fully covered with the bottom surface IST_C of the insulating structure IST. The bottom surface IST_C of the insulating structure IST may completely overlay a top surface DST2_U of the second division pattern DST2. The second peripheral spacer 182 may be interposed between the second division pattern DST2 and the dummy capping layer 144. In an embodiment, the second peripheral spacer 182 may not be interposed between the second division pattern DST2 and the dummy capping layer 144.

The insulating structure IST may be in contact with the upper portion LP_U of the landing pad LP. The insulating structure IST may be spaced apart from the lower portion LP_L of the landing pad LP. The second side surface IST_S2 of the insulating structure IST may be in contact with the upper portion LP_U of the landing pad LP. A portion of the bottom surface IST_C of the insulating structure IST may be in contact with the upper portion LP_U of the landing pad LP.

A width of the insulating structure IST in the first direction D1 may be larger than the largest width of the second division pattern DST2 in the first direction D1.

The insulating structure IST may include a protruding portion IST_IN. The protruding portion IST_IN of the insulating structure IST may be provided on the cell region CR. The protruding portion IST_IN of the insulating structure IST may be in contact with the upper portion LP_U of the landing pad LP. The protruding portion IST_IN of the insulating structure IST may be overlapped with the upper portion LP_U of the landing pad LP.

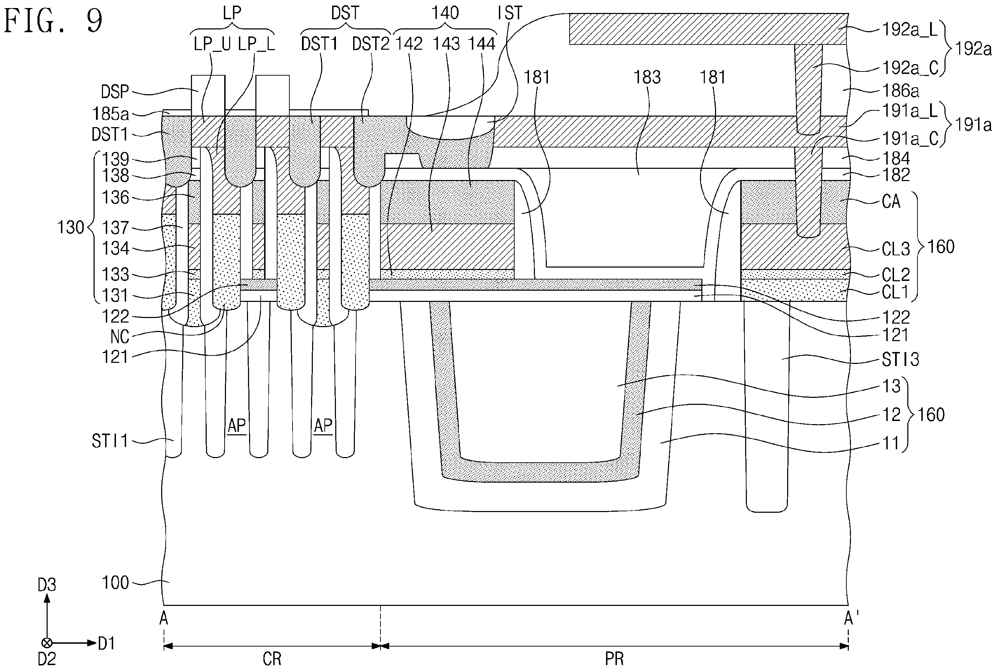

FIG. 9 is a sectional view illustrating a semiconductor device according to an embodiment of inventive concepts. Except for the features to be described below, the semiconductor device of FIG. 9 may be the same as or similar to that of FIG. 1C.

Referring to FIG. 9, the semiconductor device may include the first conductive structure 191a. The first conductive structure 191a may include a first contact portion 191a_C and a first line portion 191a_L on the first contact portion 191a_C. The first conductive structure 191a, the first contact portion 191a_C, and the first line portion 191a_L of FIG. 9 may be the same as or similar to the conductive structure 191, the contact portion 191_C, and the line portion 191_L of FIG. 1C.

A cover insulating layer 186a may be provided on the first conductive structure 191a. The cover insulating layer 186a may cover a top surface of the first conductive structure 191a. The cover insulating layer 186a may be in contact with the first conductive structure 191a and the insulating structure IST. The cover insulating layer 186a may include an insulating material.

A second conductive structure 192a may be provided on the first conductive structure 191a. The second conductive structure 192a may include a second contact portion 192a_C and a second line portion 192a_L on the second contact portion 192a_C. The second contact portion 192a_C of the second conductive structure 192a may be provided to penetrate the cover insulating layer 186a. The second contact portion 192a_C of the second conductive structure 192a may be in contact with the first conductive structure 191a. The second line portion 192a_L may be electrically connected to the first conductive structure 191a through the second contact portion 192a_C of the second conductive structure 192a. The second line portion 192a_L of the second conductive structure 192a may be extended in the first or second direction D1 or D2. The second line portion 192a_L of the second conductive structure 192a may be a bar-shaped pattern that is extended in a horizontal direction.

An upper insulating layer 185a may be spaced apart from the first conductive structure 191a. In an embodiment, the upper insulating layer 185a may be in contact with the first conductive structure 191a.

According to an embodiment of inventive concepts, a semiconductor device may include an insulating structure between a landing pad and a conductive structure. Since the insulating structure is included, the semiconductor device may not include a conductive material between the landing pad and the conductive structure. In other words, only an insulating structure (i.e., no other structure such as a conductive material) may be provided between a landing pad and a conductive structure, e.g., in a first direction. Thus, an electromagnetic interference issue may be reduced, and the electrical characteristics of the semiconductor device may be improved.

In a method of fabricating a semiconductor device, according to an embodiment of inventive concepts, the landing pads and the conductive structures may be formed to be spaced apart from each other. Thus, a distance between the landing pad and the conductive structure may be reduced, and an integration density of the semiconductor device may be increased.

While example embodiments of inventive concepts have been particularly shown and described, it will be understood by one of ordinary skill in the art that variations in form and detail may be made therein without departing from the scope of the attached claims.

## Claims

1. A semiconductor device, comprising:
a substrate including a cell region and a peripheral region;
an active pattern on the cell region of the substrate;
a gate structure on the active pattern and extending in a first direction;
a bit line structure electrically connected to the active pattern and extending in a second direction, the second direction crossing the first direction;
a node contact electrically connected to the active pattern;
a landing pad electrically connected to the node contact;
a conductive structure on the peripheral region;
a division structure enclosing the landing pad, the division structure including a first division pattern on the bit line structure and a second division pattern between the landing pad and the conductive structure; and
an insulating structure on the second division pattern,
wherein a first side surface of the insulating structure is in contact with the conductive structure, a second side surface of the insulating structure is opposite the first side surface of the insulating structure, and a bottom surface of the insulating structure connects the first side surface of the insulating structure to the second side surface of the insulating structure,
wherein a level of the bottom surface of the insulating structure is lower than a level of a top surface of the landing pad and higher than a level of a lowest portion of the second division pattern.

2. The semiconductor device of claim 1, wherein a width of the insulating structure in the first direction is smaller than a largest width of the second division pattern in the first direction.

3. The semiconductor device of claim 1 or 2, wherein the landing pad is in contact with the second division pattern and the landing pad is spaced apart from the insulating structure.

4. The semiconductor device of claim 1 or 2, wherein the second side surface of the insulating structure is in contact with the landing pad.

5. The semiconductor device of claim 4, wherein a width of the insulating structure in the first direction is larger than a largest width of the second division pattern in the first direction.

6. The semiconductor device of claim 5, wherein a portion of the bottom surface of the insulating structure is in contact with the landing pad.

7. The semiconductor device of claim 4, wherein a width of the insulating structure in the first direction is equal to a largest width of the second division pattern in the first direction.

8. The semiconductor device of any preceding claim, wherein
the conductive structure comprises a contact portion and a line portion on the contact portion, and
a level of the bottom surface of the insulating structure is higher than a level of a bottom surface of the line portion and lower than a level of a top surface of the line portion.

9. The semiconductor device of any preceding claim, further comprising:
an upper insulating layer on the second division pattern and the insulating structure, wherein
a first top surface of the second division pattern is in contact with the upper insulating layer,
a top surface of the insulating structure is in contact with the upper insulating layer, and
the first top surface of the second division pattern and the top surface of the insulating structure are coplanar with each other.

10. The semiconductor device of claim 9, wherein
a second top surface of the second division pattern is in contact with the insulating structure, and
a level of the first top surface of the second division pattern is higher than a level of the second top surface of the second division pattern.

11. The semiconductor device of claim 9 or 10, wherein
a top surface of the conductive structure is in contact with the upper insulating layer, and
the top surface of the conductive structure and the top surface of the insulating structure are coplanar with each other.

12. The semiconductor device of any preceding claim, wherein the second division pattern and the insulating structure comprise a same insulating material.

13. A semiconductor device, comprising:
a substrate including a cell region and a peripheral region;
an active pattern on the cell region of the substrate;
a gate structure on the active pattern and extending in a first direction;
a bit line structure electrically connected to the active pattern and extending in a second direction, the second direction crossing the first direction;
a node contact electrically connected to the active pattern;
a landing pad electrically connected to the node contact;
a conductive structure on the peripheral region;
a division structure enclosing the landing pad, the division structure including a first division pattern on the bit line structure and a second division pattern between the landing pad and the conductive structure; and
an insulating structure on the second division pattern, wherein:
the insulating structure is between the landing pad and the conductive structure, and
a side surface of the conductive structure is in contact with the second division pattern and the insulating structure.

14. The semiconductor device of claim 13, wherein
a lower portion of the landing pad is connected to the node contact,
a level of an upper portion of the landing pad is higher than a level of the bit line structure, and
a level of a lowest portion of the insulating structure is higher than a level of a lower portion of the landing pad.

15. The semiconductor device of claim 14, wherein
the insulating structure is in contact with the upper portion of the landing pad, and
the insulating structure is spaced apart from the lower portion of the landing pad.
